# EUROPÄISCHE PATENTSCHRIFT

(11) **EP 3 798 654 B1**
(45) Veröffentlichungstag und Bekanntmachung des Hinweises auf die Patenterteilung: **31.07.2024**
(21) Anmeldenummer: 19199828.5
(22) Anmeldetag: 26.09.2019
(51) Int. Cl.: G01R 33/28

(54) **MAGNETRESONANZVORRICHTUNG MIT EINER MIKROFONEINHEIT**
MAGNETIC RESONANCE DEVICE COMPRISING A MICROPHONE UNIT
DISPOSITIF DE RÉSONANCE MAGNÉTIQUE DOTÉ D'UNE UNITÉ DE MICROPHONE

(43) Veröffentlichungstag der Anmeldung: 31.03.2021
(73) Patentinhaber: Siemens Healthineers AG, 91301 Forchheim (DE)
(72) Erfinder: Höcht, Philipp, 91207 Lauf (DE)
(74) Vertreter: Siemens Healthineers Patent Attorneys

(56) Entgegenhaltungen:
- DE-A1- 102004 042 100
- DE-A1- 102014 214 265
- US-A1- 2018 128 888

## Beschreibung

Die vorliegende Erfindung betrifft eine Magnetresonanzvorrichtung mit einer Scannereinheit, einem von der Scannereinheit zumindest teilweise umgebenen Patientenaufnahmebereich, wobei die Scannereinheit eine Gehäuseeinheit umfasst, die den Patientenaufnahmebereich zumindest teilweise umgibt, und einer Kommunikationseinheit mit zumindest einer Mikrofoneinheit.

Während einer medizinischen und/oder diagnostischen Magnetresonanzuntersuchung an einem Patienten ist es vorgesehen, dass ein Bedienpersonal, beispielsweise ein die Magnetresonanzuntersuchung betreuender Arzt oder MTA, mit dem Patienten kommuniziert. Zum einen werden hierbei Anweisungen, wie beispielsweise Atemanweisungen, an den Patienten übermittelt, zum anderen kann der Patient auch sein Befinden dem Bedienpersonal mitteilen, wie beispielsweise wenn der Patient Angstzustände hat aufgrund der Enge im Patientenaufnahmebereich einer Magnetresonanzvorrichtung. Hierzu weist für gewöhnlich die Magnetresonanzvorrichtung eine Kommunikationseinheit auf. Eine derartige Kommunikationseinheit kann dabei auf Patientenseite eine Eingabeeinheit und eine Ausgabeeinheit, wie beispielsweise einen Kopfhörer und ein Mikrofon, aufweisen. Zudem kann die Kommunikationseinheit auch auf Benutzerseite eine Eingabeeinheit und eine Ausgabeeinheit aufweisen. Solche Kommunikationseinheiten sind beispielsweise aus der US2018/128888 A1 oder der DE102004042100 A1 bekannt.

Eine Integration des Mikrofons auf Patientenseite weist jedoch einige Schwierigkeiten auf. Beispielsweise ist eine Anordnung des Mikrofons in einem Liegentisch kritisch, da bei einer Abdeckung des Patienten dies zu auch zu einer Abdeckung des Mikrofons führen kann. Eine Anordnung des Mikrofons in einem Headset für den Patienten ist zwar möglich, jedoch weist diese Anordnung eine nur geringe Akzeptanz durch die Patienten auf. Zudem kann das Mikrofon auch innerhalb einer Hochfrequenzantenneneinheit, die fest innerhalb einer Scannereinheit der Magnetresonanzvorrichtung angeordnet und/oder integriert ist, fest angeordnet sein. Jedoch ist hier das Mikrofon besonders nahe an einer Lärmquelle, insbesondere der Gradientenspuleneinheit der Scannereinheit, während der Magnetresonanzuntersuchung angeordnet. Hierdurch können bevorzugt Schallwellen und Vibrationen direkt auf das Mikrofon übertragen werden und somit auch zu unerwünschten Störgeräuschen während einer Kommunikation des Bedienpersonals mit dem Patienten führen.

Der vorliegenden Erfindung liegt insbesondere die Aufgabe zugrunde, eine von Störgeräuschen entkoppelte Anordnung eines Mikrofons der Kommunikationseinheit bereitzustellen. Die Aufgabe wird durch die Merkmale des unabhängigen Anspruchs gelöst. Vorteilhafte Ausgestaltungen sind in den Unteransprüchen beschrieben.

Die Erfindung geht aus von einer Magnetresonanzvorrichtung mit einer Scannereinheit, einem von der Scannereinheit zumindest teilweise umgebenen Patientenaufnahmebereich, wobei die Scannereinheit eine Gehäuseeinheit umfasst, die den Patientenaufnahmebereich zumindest teilweise umgibt, und einer Kommunikationseinheit mit zumindest einer Mikrofoneinheit. Erfindungsgemäß weist die zumindest eine Mikrofoneinheit zumindest ein Entkopplungselement auf, wobei die zumindest eine Mikrofoneinheit mittels des Entkopplungselements schwingungsentkoppelt an der Gehäuseeinheit angeordnet ist.

Die Scannereinheit weist typischerweise einen Grundmagneten auf zur Erzeugung eines möglichst homogenen und konstanten Grundmagnetfelds auf. Zudem weist die Scannereinheit eine Gradientenspuleneinheit, die zur Erzeugung eines Gradientenfelds während einer Magnetresonanzuntersuchung ausgelegt ist, und eine Hochfrequenzantenneneinheit auf. Die Hochfrequenzantenneneinheit ist fest innerhalb der Scannereinheit angeordnet und/oder integriert und zur Aussendung von Magnetresonanzsequenzen in den Patientenaufnahmebereiche ausgelegt. Die Gehäuseeinheit ist bevorzugt diejenige Einheit innerhalb der Scannereinheit, die direkt um den Patientenaufnahmebereich der Magnetresonanzvorrichtung angeordnet ist. Zudem kann hierbei die den Patientenaufnahmebereich umgebende Gehäuseeinheit auch einstückig und/oder einteilig mit der Hochfrequenzantenneneinheit ausgebildet sein.

Die Gehäuseeinheit umfasst dabei eine Begrenzung des Patientenaufnahmebereichs in radialer Richtung. Der Patientenaufnahmebereich ist typischerweise zylinderförmig von der Scannereinheit umgeben. Insbesondere ist hierbei der Patientenaufnahmebereich typischerweise zylinderförmig von der Gehäuseeinheit umgeben. Der Patientenaufnahmebereich ist dazu ausgebildet, während einer Magnetresonanzuntersuchung den Patienten, insbesondere den zu untersuchenden Bereich des Patienten, aufzunehmen. Hierzu ist der Patient bevorzugt auf einem Patiententisch, der innerhalb des Patientenaufnahmebereichs in horizontaler Richtung, insbesondere in z-Richtung und/oder in Längserstreckung des Patiententischs, bewegbar ist, gelagert und/oder positioniert.

Die Kommunikationseinheit ist zu einer Kommunikation zwischen dem Patienten und einem medizinischen Bedienpersonal während einer Magnetresonanzuntersuchung an dem Patienten ausgelegt. Mittels der Kommunikationseinheit kann vorzugsweise das medizinische Bedienpersonal dem Patienten Anweisungen, beispielsweise ein Atemkommando an den Patienten, während der Magnetresonanzvorrichtung mitteilen. Zudem kann auch der Patient dem medizinischen Bedienpersonal sein Befinden und/oder ein Unwohlsein mitteilen, wie beispielsweise wenn der Patient Angstzustände hat aufgrund der Enge im Patientenaufnahmebereich einer Magnetresonanzvorrichtung.

Vorzugsweise weist hierzu die Kommunikationseinheit auf Benutzerseite eine Benutzer-Eingabeeinheit, insbesondere eine akustische Eingabeeinheit wie beispielsweise eine Mikrofoneinheit, und eine Benutzer-Ausgabeeinheit, insbesondere eine akustische Ausgabeeinheit wie beispielsweise eine Lautsprechereinheit, auf. Zudem weist die Kommunikationseinheit auf Patientenseite ebenfalls eine Patienten-Eingabeeinheit und eine Patienten-Ausgabeeinheit auf. Die Ausgabeeinheit kann dabei eine optische Ausgabeeinheit umfassen. Besonders vorteilhaft jedoch umfasst die Ausgabeeinheit eine akustische Ausgabeeinheit, wie beispielsweise Kopfhörer. Die Eingabeeinheit umfasst eine Mikrofoneinheit mit zumindest einem Mikrofon.

Das Entkopplungselement ist bevorzugt dazu ausgelegt, Vibrationen und/oder Körperschallwellen, die insbesondere von der Gradientenspuleneinheit erzeugt werden, von der Mikrofoneinheit zu entkoppeln. Das Entkopplungselement kann von allen dem Fachmann als sinnvoll erscheinenden Elementen gebildet sein, die eine vorteilhaft Entkopplung von Vibrationen und/oder Körperschallwellen ermöglichen. Besonders vorteilhaft jedoch umfasst das Entkopplungselement ein Gummimaterial, wie beispielsweise einen Gummiring. Derart kann ein besonders kostengünstiges Entkopplungselement für die schwingungsentkoppelte Anordnung und/oder Lagerung an der Gehäuseeinheit der Mikrofoneinheit bereitgestellt werden.

Die Mikrofoneinheit ist an der den Patientenaufnahmebereich umgebenden Gehäuseeinheit angeordnet. Insbesondere ist die Mikrofoneinheit derart an der Gehäuseeinheit, insbesondere an der den Patientenaufnahmebereich umgebenden Gehäuseeinheit, angeordnet, dass ein Erfassungsbereich eines Mikrofons der Mikrofoneinheit in den Patientenaufnahmebereich hineinragt. Durch die erfindungsgemäße Ausgestaltung kann vorteilhaft eine von Störgeräuschen entkoppelte Anordnung der Mikrofoneinheit erreicht werden.

Vorzugsweise umfasst die Kommunikationseinheit zwei oder mehr Mikrofoneinheiten, die verteilt an der Gehäuseeinheit angeordnet und/oder gelagert sind. Bevorzugt sind die einzelnen Mikrofoneinheiten verteilt an der Gehäuseeinheit, insbesondere an der den Patientenaufnahmebereich umgebenden Gehäuseeinheit, angeordnet und/oder gelagert, so dass eine zuverlässige Erfassung von Kommunikationssignalen des Patienten innerhalb des gesamten Patientenaufnahmebereichs erreicht werden kann. Insbesondere kann die zuverlässige Erfassung von Kommunikationssignalen des Patienten auch unabhängig von einer Position des Patienten erreicht werden.

In einer vorteilhaften Weiterbildung der Magnetresonanzvorrichtung kann es vorgesehen sein, dass die Gehäuseeinheit zumindest eine Aussparung zu einer Aufnahme der zumindest einen Mikrofoneinheit aufweist. Aufgrund der Aussparung kann eine besonders platzsparende Anordnung der zumindest einen Mikrofoneinheit an der Gehäuseeinheit, insbesondere an der den Patientenaufnahmebereich umgebenden Gehäuseeinheit, erreicht werden. Insbesondere kann derart eine Anordnung in Patientennähe während einer Magnetresonanzuntersuchung bereitgestellt werden. Vorzugsweise weist hierbei die Gehäuseeinheit, insbesondere die den Patientenaufnahmebereich umgebende Gehäuseeinheit, für jede Mikrofoneinheit der Kommunikationseinheit eine eigene Aussparung auf.

In einer vorteilhaften Weiterbildung der Magnetresonanzvorrichtung kann es vorgesehen sein, dass das zumindest eine Entkopplungselement an einem Randbereich der Aussparung angeordnet ist. Insbesondere kann derart eine schalldichte Anordnung der zumindest einen Mikrofoneinheit an der Gehäuseeinheit erreicht werden. Der Randbereich der zumindest einen Aussparung umfasst bevorzugt einen Übergang von der zumindest einen Mikrofoneinheit zu der Gehäuseeinheit, insbesondere zu der den Patientenaufnahmebereich umgebenden Gehäuseeinheit. Ein derartiger Übergang ist besonders kritisch hinsichtlich einer Schallentkopplung und/oder Vibrationsentkopplung. Mittels des Entkopplungselements, das bevorzugt den gesamten Randbereich der zumindest einen Aussparung abdichtet, kann jedoch besonders vorteilhaft eine schalldichte und/oder eine schallentkoppelte und/oder eine vibrationsentkoppelte Anordnung der Mikrofoneinheit an der Gehäuseeinheit, insbesondere der den Patientenaufnahmebereich umgebenden Gehäuseeinheit, erreicht werden. Zudem können derart Störgeräusche bei der Erfassung von Kommunikationssignalen des Patienten vorteilhaft reduziert und/oder vermieden werden.

Erfindungsgemäß weist die zumindest eine Mikrofoneinheit ein Mikrofon-Board mit einem Mikrofon auf.

Ein Mikrofon-Board umfasst bevorzugt eine Platine und/oder eine Leiterplatte, auf der das Mikrofon angeordnet ist. Zudem können auf dem Mikrofon-Board, insbesondere der Platine, weitere, dem Fachmann als sinnvoll erscheinende Bauteile, insbesondere elektronische Bauteile, angeordnet sein, wie beispielsweise Bauteile zu einer Versorgungsspannungsstabilisierung und/oder zu einem Überspannungsschutz des Mikrofons usw.

Das Mikrofon kann dabei in einer vorteilhaften Ausbildung besonders klein ausgebildet sein, wie beispielsweise als miniaturisiertes Mikrofon und/oder als MEMS(Micro Electro Mechanical System)-Mikrofon. Ein derartiges Mikrofon weist bevorzugt eine Länge und/oder Breite im mm-Bereich auf. Einzelne Bauteile eines miniaturisierten Mikrofons und/oder eines MEMS-Mikrofons können auch Abmessungen im pm-Bereich aufweisen. Vorteilhafterweise umfasst eine maximale Länge und/oder eine maximale Breite des miniaturisierten Mikrofons und/oder des MEMS-Mikrofons 10 mm. Vorteilhafterweise umfasst eine maximale Länge und/oder eine maximale Breite des miniaturisierten Mikrofons und/oder des MEMS-Mikrofons 8 mm. Vorteilhafterweise umfasst eine maximale Länge und/oder eine maximale Breite des miniaturisierten Mikrofons und/oder des MEMS-Mikrofons 6 mm. Vorteilhafterweise umfasst eine maximale Länge und/oder eine maximale Breite des miniaturisierten Mikrofons und/oder des MEMS-Mikrofons 4 mm. Dies ermöglicht ein besonders kompaktes und bauraumsparendes Mikrofon für die zumindest eine Mikrofoneinheit bereitzustellen und damit auch die Mikrofoneinheit besonders bauraumsparend und/oder kompakt zu gestalten.

In einer vorteilhaften Weiterbildung der Magnetresonanzvorrichtung kann es vorgesehen sein, dass das Mikrofon an einer dem Patientenaufnahmebereich zugewandten Seite des Mikrofon-Boards angeordnet ist. Hierdurch kann vorteilhaft ein unverdeckter Erfassungsbereich des Mikrofons in den Patientenaufnahmebereich hinein bereitgestellt werden.

Alternativ zu der Anordnung des Mikrofons an einer dem Patientenaufnahmebereich zugewandten Seite des Mikrofon-Boards kann das Mikrofon auch auf der dem Patientenaufnahmebereich abgewandten Seite des Mikrofon-Boards angeordnet sein, wobei hier bevorzugt das Mikrofon-Board eine Schallöffnung für das Mikrofon aufweisen kann.

Erfindungsgemäß weist die zumindest eine Mikrofoneinheit ein Anschluss-Board, vorzugsweise mit einer Schnittstelle auf. Das Anschluss-Board umfasst bevorzugt eine Platine und/oder Leiterplatte, auf der eine Schnittstelle der Mikrofoneinheit und angeordnet ist. Zudem können auf dem Anschluss-Board, insbesondere der Platine und/oder Leiterplatte, weitere, dem Fachmann als sinnvoll erscheinende Bauteile, insbesondere elektronische Bauteile, angeordnet sein. Die Schnittstelle ist bevorzugt an einer dem Mikrofon-Board abgewandten Seite des Anschluss-Boards angeordnet. Mittels der Schnittstelle können bevorzugt Kommunikationssignale, insbesondere mittels des Mikrofons erfasste Kommunikationssignale, an weitere Einheiten der Kommunikationseinheit, wie beispielsweise eine Verarbeitungseinheit der Kommunikationseinheit, übertragen werden. Auch kann mittels der Schnittstelle eine vorteilhafte Energieversorgung der zumindest einen Mikrofoneinheit bereitgestellt werden.

Das Anschlussboard ist bevorzugt beabstandet zu dem Mikrofon-Board angeordnet, wobei zwischen dem Anschluss-Board und dem Mikrofon-Board eine Zwischenschicht angeordnet ist. Insbesondere weisen das Anschluss-Board und das Mikrofon-Board eine im Wesentlichen gleiche Grundfläche auf. Dabei kann das Anschluss-Board deckungsgleich zu dem Mikrofon-Board angeordnet und/oder ausgebildet sein.

In einer vorteilhaften Weiterbildung der Magnetresonanzvorrichtung kann es vorgesehen sein, dass die zumindest eine Mikrofoneinheit ein Verbindungselement zur mechanischen Verbindung des Anschluss-Boards mit dem Mikrofon-Board aufweist. Das Verbindungselement umfasst bevorzugt ein Sicherungselement, um das Mikrofon-Board sicher und/oder verliersicher an dem Anschluss-Board anzuordnen. Dabei kann das Verbindungselement beispielsweise eine Schraube und/oder ein Rastelement und/oder ein Klemmelement usw. umfassen. Vorzugsweise weisen hierzu das Mikrofon-Board und/oder das Anschluss-Board ein zu dem Verbindungselement korrespondierendes Element auf, das eine mechanische Verbindung ermöglicht. Ist beispielsweise das Verbindungselement eine Schraube, so können die korrespondierenden Elemente Aussparungen zur Durchführung der Schraube und/oder auch Gewindeaufnahmen, wie insbesondere eine Schraubenmutter, umfassen. Durch diese Ausgestaltung der Erfindung kann eine besonders einfache mechanische Verbindung des Mikrofon-Boards mit dem Anschluss-Board und/oder eine einfache Sicherung des Mikrofon-Boards an dem Anschluss-Board erreicht werden. Besonders vorteilhaft kann dies erreicht werden, wenn das Verbindungselement eine Schraube, insbesondere eine verliersichere Schraube, umfasst. Ein weiterer Vorteil dieser Ausgestaltung der Erfindung ist, dass ein einfacher Ausbau und/oder Wechsel des Mikrofon-Boards möglich ist. Insbesondere kann hierbei das Mikrofon-Board ohne eine Demontage der den Patientenaufnahmebereich umgebenden Gehäuseschale von der Scannereinheit ausgebaut und/oder ausgewechselt werden. Zudem kann hierbei auch das Mikrofon-Board unabhängig von dem Anschluss-Board ausgebaut und/oder ausgewechselt werden.

Erfindungsgemäß weist die zumindest eine Mikrofoneinheit zwei oder mehr in ihrer Länge variable Kontaktelemente auf, die zwischen dem Anschluss-Board und dem Mikrofon-Board angeordnet sind. Die zwei oder mehr in ihrer Länge variablen Kontaktelemente umfassen jeweils eine Kontaktfeder. Die zwei oder mehr in ihrer Länge variablen Kontaktfedern, sind bevorzugt verteilt auf einer Fläche des Anschluss-Boards und/oder des Mikrofon-Boards angeordnet, so dass ein möglichst einheitlicher Abstand zwischen dem Anschluss-Board und dem Mikrofon-Board erreicht werden kann. Zudem kann durch die Anordnung von mindestens zwei in ihrer Länge variablen Kontaktelemente vorteilhaft ein geschlossener Stromkreis zwischen dem Anschluss-Board und dem Mikrofon-Board bereitgestellt werden. Des Weiteren kann eine sichere und/oder redundante Signalübertragung zwischen dem Mikrofon-Board und dem Anschluss-Board bereitgestellt werden. Zudem können auch bei einer von der Spannungsversorgung getrennten differentiellen Übertragung eines Audiosignals vier in ihrer Länge variable Kontaktelemente zwischen dem Mikrofon-Board und dem Anschluss-Board angeordnet sein, um zwei geschlossene Kreis zur Spannungsversorgung und Signalübertragung bereitzustellen. Weist die Mikrofoneinheit nur ein einziges, in seiner Länge einstellbares Kontaktelement auf, kann beispielsweise ein Befestigungselement und/oder Sicherungselement zur Befestigung und/oder Sicherung des Mikrofon-Boards an dem Anschluss-Board als zweiter Kontakt zur Herstellung eines geschlossenen Stromkreises zwischen dem Mikrofon-Board und dem Anschluss-Board ausgebildet sein. Beispielsweise kann eine Befestigungsschraube und/oder Sicherungsschraube dabei als spannungsführendes Element zwischen dem Mikrofon-Board und dem Anschluss-Board ausgebildet sein.

Das in seiner Länge variable Kontaktelement, also die Kontaktfeder, ist dazu ausgelegt, einen Kontakt, insbesondere einen elektrischen Kontakt, zwischen dem Anschluss-Board und dem Mikrofon-Board herzustellen. Das in seiner Länge variable Kontaktelement weist eine maximale Länge auf, bei der das in seiner Länge variable Kontaktelement bevorzugt entspannt angeordnet ist. Zudem kann das in seiner Länge variable Kontaktelement auch in einem komprimierten Zustand zwischen dem Anschluss-Board und dem Mikrofon-Board angeordnet sein. Sobald ein Kontakt zwischen dem Mikrofon-Board bzw. dem Anschluss-Board und dem in seiner Länge variablen Kontaktelement vorhanden ist, liegt ein elektrischer Kontakt zwischen dem in seiner Länge variablen Kontaktelement und dem Mikrofon-Board bzw. dem Anschluss-Board vor. Weist die Mikrofoneinheit ein miniaturisiertes Mikrofon und/oder ein MEMS-Mikrofon auf, ist bevorzugt auch das in seiner Länge variable Kontaktelement, also die Kontaktfeder, als miniaturisiertes Kontaktelement ausgebildet. Beispielsweise umfasst das in seiner Länge variable Kontaktelement, also die Kontaktfeder, eine Miniatur-Kontaktfeder, so dass eine besonders kompakte und bauraumsparende Mikrofoneinheit erreicht werden kann. Eine derartige Miniatur-Kontaktfeder weist bevorzugt eine Länge im mm-Bereich auf. Vorteilhafterweise umfasst eine maximale Länge der Miniatur-Kontaktfeder 6 mm. Vorteilhafterweise umfasst eine maximale Länge der Miniatur-Kontaktfeder 5 mm. Vorteilhafterweise umfasst eine maximale Länge der Miniatur-Kontaktfeder 4 mm. Vorteilhafterweise umfasst eine maximale Länge der Miniatur-Kontaktfeder 3 mm. Eine Kontaktfläche der Miniatur-Kontaktfeder für eine Kontaktierung des Anschluss-Boards und/oder des Mikrofon-Boards ist bevorzugt kleiner 1 mm ausgebildet. Die Kontaktfläche der Miniatur-Kontaktfeder kann bevorzugt kleiner 0,8 mm sein.

Erfindungsgemäß weist das Mikrofon-Board konzentrische Leiterbahnen auf, auf die an zumindest einer Stelle unterbrochen sind. Vorzugsweise umfasst hierbei das Mikrofon-Board und/oder das Anschluss-Board eine kreisförmige Platine, bei der eine Orientierung nicht sichergestellt werden kann, wobei mittels der konzentrischen Leiterbahnen eine einfache Montage des Anschluss-Boards und/oder des Mikrofon-Boards ermöglicht werden kann. Mittels der Unterbrechung der konzentrischen Leiterbahnen können unerwünschte Wirbelströme innerhalb der Mikrofoneinheit verhindert werden. Zudem kann eine einfache Anordnung und/oder Kontaktierung des zumindest einen in seiner Länge variablen Kontaktelements oder auch der zwei oder mehr in ihrer Länge variablen Kontaktelemente mittels der Leiterbahnen ermöglicht werden. Erfindungsgemäß sind die konzentrischen Leiterbahnen auf einer dem Anschluss-Board zugewandten Seite des Mikrofon-Boards angeordnet. Zudem können die konzentrischen Leiterbahnen auch auf dem Anschluss-Board, insbesondere auf einer dem Mikrofon-Board zugewandten Seite des Anschluss-Boards, angeordnet sein, so dass ein einfacher Austausch von in ihrer Länge variablen Kontaktelementen, die zwischen dem Anschluss-Board und dem Mikrofon-Boards angeordnet sind, erreicht werden kann. Zwar kann es sein, dass durch die Unterbrechung der konzentrischen Leiterbahnen zusätzliche in ihrer Länge variablen Kontaktelemente benötigt werden, um eine zufällige Anordnung eines der in ihrer Länge variablen Kontaktelemente an der Unterbrechung der konzentrischen Leiterbahnen zu kompensieren. Trotzdem ist eine derartige Ausgestaltung eine einfache Implementierung einer Kontaktierung zwischen dem Anschluss-Board und dem Mikrofon-Board.

In einer vorteilhaften Weiterbildung der Magnetresonanzvorrichtung kann es vorgesehen sein, dass die zumindest eine Mikrofoneinheit zumindest ein weiteres elektronisches Bauelement aufweist. Bevorzugt ist das zumindest eine weitere elektronische Bauelement an dem Mikrofon-Board angeordnet. Ein derartiges elektronisches Bauelement kann beispielsweise eine Diode, insbesondere eine Z-Diode oder Zener-Diode, und/oder ein Kondensator und/oder weitere, dem Fachmann als sinnvoll erscheinenden elektronischen Bauelemente umfassen. Beispielsweise kann mittels einer Diode vorteilhaft eine Spannungsversorgung der Mikrofoneinheit, insbesondere für das Mikrofon, geschützt werden. Zudem kann auch eine vorteilhafte Spannungsstabilisierung mittels beispielsweise eines Kondensators während eines Betriebs der Mikrofoneinheit erreicht werden.

In einer vorteilhaften Weiterbildung der Magnetresonanzvorrichtung kann es vorgesehen sein, dass die zumindest eine Mikrofoneinheit einen Durchmesser von maximal 2 cm aufweist. Bevorzugt weist die Mikrofoneinheit einen Durchmesser von maximal 1,8 cm auf. Bevorzugt weist die Mikrofoneinheit einen Durchmesser von maximal 1,6 cm auf. Bevorzugt weist die Mikrofoneinheit einen Durchmesser von maximal 1,4 cm auf. Bevorzugt weist die Mikrofoneinheit einen Durchmesser von maximal 1,2 cm auf. Besonders vorteilhaft weist hierbei das Mikrofon-Board und/oder das Anschluss-Board einen Durchmesser von maximal 1,8 cm auf. Besonders vorteilhaft weist hierbei das Mikrofon-Board und/oder das Anschluss-Board einen Durchmesser von maximal 1,6 cm auf. Besonders vorteilhaft weist hierbei das Mikrofon-Board und/oder das Anschluss-Board einen Durchmesser von maximal 1,4 cm auf. Besonders vorteilhaft weist hierbei das Mikrofon-Board und/oder das Anschluss-Board einen Durchmesser von maximal 1,2 cm auf. Besonders vorteilhaft weist hierbei das Mikrofon-Board und/oder das Anschluss-Board einen Durchmesser von maximal 1,0 cm auf. Besonders vorteilhaft weist hierbei das Mikrofon-Board und/oder das Anschluss-Board einen Durchmesser von maximal 0,9 cm auf. Derart kann eine besonders kompakte Mikrofoneinheit zur Kommunikation zwischen dem Patienten und dem medizinischen Bedienpersonal während einer Magnetresonanzuntersuchung bereitgestellt werden. Zudem können derart auch Öffnungen, insbesondere Schallöffnungen, und/oder Aussparungen innerhalb der Gehäuseeinheit besonders klein gehalten werden, und damit eine Schallübertragung und/oder eine Vibrationsübertragung in den Patientenaufnahmebereich hinein reduziert werden.

In einer vorteilhaften Weiterbildung der Magnetresonanzvorrichtung kann es vorgesehen sein, dass die Scannereinheit eine fest in der Scannereinheit angeordnete Hochfrequenzantenneneinheit aufweist, wobei die Hochfrequenzantenneneinheit einstückig mit der Gehäuseeinheit ausgebildet ist. Vorzugsweise ist hierbei die zumindest eine Mikrofoneinheit direkt in die Hochfrequenzantenneneinheit integriert.

Weitere Vorteile, Merkmale und Einzelheiten der Erfindung ergeben sich aus dem im Folgenden beschriebenen Ausführungsbeispiel sowie anhand der Zeichnungen.

Es zeigen:
- Fig. 1: eine erfindungsgemäße Magnetresonanzvorrichtung mit einer Kommunikationseinheit in einer schematischen Darstellung,
- Fig. 2: einen Ausschnitt einer Hochfrequenzantenneneinheit mit einer Mikrofoneinheit,
- Fig. 3: eine Ansicht von oben auf ein Anschluss-Board der Mikrofoneinheit,
- Fig. 4: eine Ansicht von unten auf das Anschluss-Board der Mikrofoneinheit,
- Fig. 5: eine Ansicht von oben auf ein Mikrofon-Board der Mikrofoneinheit,
- Fig. 6: Ansicht von unten auf ein Mikrofon-Board der Mikrofoneinheit.

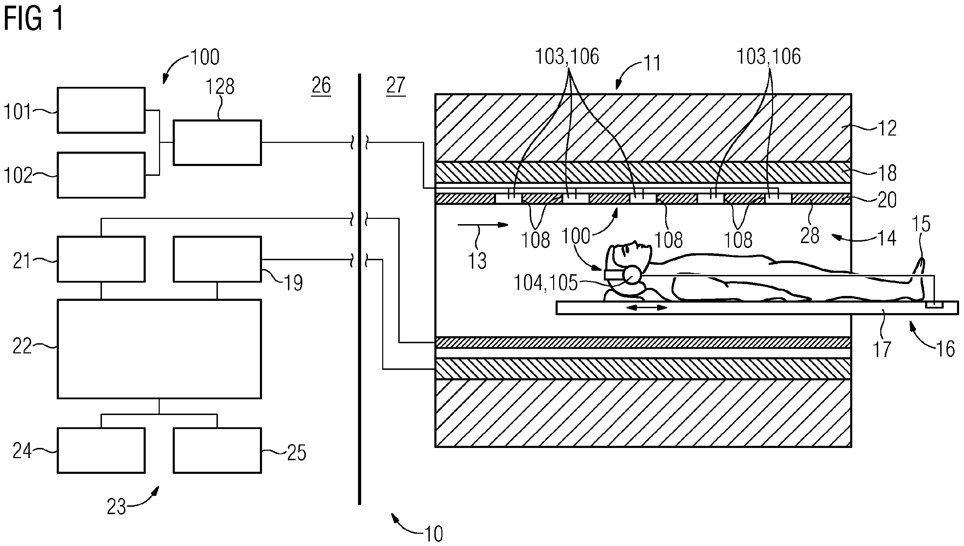

In der Fig. 1 ist eine Magnetresonanzvorrichtung 10 schematisch dargestellt. Die Magnetresonanzvorrichtung 10 umfasst eine von einer Magneteinheit gebildete Scannereinheit 11, die einen supraleitenden Grundmagneten 12 zu einem Erzeugen eines starken und insbesondere konstanten Grundmagnetfelds 13 umfasst. Zudem weist die Magnetresonanzvorrichtung 10 einen Patientenaufnahmebereich 14 auf zu einer Aufnahme eines Patienten 15. Der Patientenaufnahmebereich 14 im vorliegenden Ausführungsbeispiel ist zylinderförmig ausgebildet und in einer Umfangsrichtung von der Scannereinheit 11 zylinderförmig umgeben. Grundsätzlich ist jedoch eine davon abweichende Ausbildung des Patientenaufnahmebereichs 14 jederzeit denkbar. Der Patient 15 kann mittels einer Patientenlagerungsvorrichtung 16 der Magnetresonanzvorrichtung 10 in den Patientenaufnahmebereich 14 geschoben und/oder gefahren werden. Die Patientenlagerungsvorrichtung 16 weist hierzu einen innerhalb des Patientenaufnahmebereichs 14 bewegbar ausgestalteten Patiententisch 17 auf.

Die Scannereinheit 11, insbesondere die Magneteinheit, weist weiterhin eine Gradientenspuleneinheit 18 zu einer Erzeugung von Magnetfeldgradienten auf, die für eine Ortskodierung während einer Bildgebung verwendet werden. Die Gradientenspuleneinheit 18 wird mittels einer Gradientensteuereinheit 19 der Magnetresonanzvorrichtung 10 gesteuert. Die Scannereinheit 11, insbesondere die Magneteinheit, umfasst weiterhin eine Hochfrequenzantenneneinheit 20 zu einer Anregung einer Polarisation, die sich in dem von dem Grundmagneten 12 erzeugten Grundmagnetfeld 13 einstellt. Die Hochfrequenzantenneneinheit 20 wird von einer Hochfrequenzantennensteuereinheit 21 der Magnetresonanzvorrichtung 10 gesteuert und strahlt hochfrequente Magnetresonanzsequenzen in einen Untersuchungsraum, der im Wesentlichen vom Patientenaufnahmebereich 14 der Magnetresonanzvorrichtung 10 gebildet ist, ein.

Die Scannereinheit 11, insbesondere die Magneteinheit, weist weiterhin eine Gehäuseeinheit 28 auf, wobei die Gehäuseeinheit 28 direkt den Patientenaufnahmebereich 14 zylinderförmig umgibt. Die Gehäuseeinheit 28 ist im vorliegenden Ausführungsbeispiel einstückig und/oder einteilig mit der Hochfrequenzantenneneinheit 20 ausgebildet, so dass im vorliegenden Ausführungsbeispiel auch die Hochfrequenzantenneneinheit 20 direkt den Patientenaufnahmebereich 14 zylinderförmig umgibt.

Zu einer Steuerung des Grundmagneten 12, der Gradientensteuereinheit 19 und zur Steuerung der Hochfrequenzantennensteuereinheit 21 weist die Magnetresonanzvorrichtung 10 eine Systemsteuereinheit 22 auf. Die Systemsteuereinheit 22 steuert zentral die Magnetresonanzvorrichtung 10, wie beispielsweise das Durchführen einer vorbestimmten bildgebenden Gradientenechosequenz. Zudem umfasst die Systemsteuereinheit 22 eine nicht näher dargestellte Auswerteeinheit zu einer Auswertung von medizinischen Bilddaten, die während der Magnetresonanzuntersuchung erfasst werden.

Des Weiteren umfasst die Magnetresonanzvorrichtung 10 eine Benutzerschnittstelle 23, die mit der Systemsteuereinheit 22 verbunden ist. Steuerinformationen wie beispielsweise Bildgebungsparameter, sowie rekonstruierte Magnetresonanzbilder können auf einer Anzeigeeinheit 24, beispielsweise auf zumindest einem Monitor, der Benutzerschnittstelle 23 für ein medizinisches Bedienpersonal angezeigt werden. Weiterhin weist die Benutzerschnittstelle 23 eine Eingabeeinheit 25 auf, mittels der Informationen und/oder Parameter während eines Messvorgangs von dem medizinischen Bedienpersonal eingegeben werden können.

Für eine Kommunikation zwischen dem Patienten 15 und dem medizinischen Bedienpersonal während einer Magnetresonanzuntersuchung weist die Magnetresonanzvorrichtung 10 eine Kommunikationseinheit 100 auf. Die Kommunikationseinheit 100 weist auf Benutzerseite eine Benutzer-Eingabeeinheit 101 und eine Benutzer-Ausgabeeinheit 102 auf. Die Benutzer-Eingabeeinheit 101 umfasst im vorliegenden Ausführungsbeispiel eine akustische Benutzer-Eingabeeinheit, wie beispielsweise ein Mikrofon. Die Benutzer-Ausgabeeinheit 102 umfasst im vorliegenden Ausführungsbeispiel eine akustische Benutzer-Ausgabeeinheit, wie beispielsweise Lautsprecher. Zudem kann Kommunikationseinheit 100 auf Benutzerseite auch eine optische Eingabeeinheit und/oder eine optische Ausgabeeinheit, wie beispielsweise einen Monitor und/oder ein Display, umfassen.

Die Benutzer-Eingabeeinheit 101 und eine Benutzer-Ausgabeeinheit 102 sind innerhalb eines Überwachungsraums 26 angeordnet. Der Überwachungsraum 26 ist getrennt von einem Untersuchungsraum 27, in dem die Magnetresonanzvorrichtung 10 angeordnet ist, angeordnet. Insbesondere sind der Überwachungsraum 26 und der Untersuchungsraum 27 hinsichtlich eines Austauschs von Hochfrequenzsignalen und/oder von elektromagnetischer Strahlung voneinander abgeschirmt. Innerhalb des Überwachungsraums 26 ist bevorzugt auch die Systemsteuerungseinheit zusammen mit der Benutzerschnittstelle angeordnet.

Die Kommunikationseinheit 100 weist weiterhin auf Patientenseite eine Patienten-Eingabeeinheit 103 und eine Patienten-Ausgabeeinheit 104 auf. Die Patienten-Eingabeeinheit 103 und die Patienten-Ausgabeeinheit 104 sind innerhalb des Untersuchungsraums 27 angeordnet. Die Patienten-Ausgabeeinheit 104 umfasst eine akustische Patienten-Ausgabeeinheit 104, die einen Kopfhörer 105 umfasst. Die Patienten-Eingabeeinheit 103 umfasst eine akustische Patienten-Eingabeeinheit 103, die zumindest eine Mikrofoneinheit 106 umfasst. Die zumindest eine Mikrofoneinheit 106 ist an der Gehäuseeinheit 28, im vorliegenden Ausführungsbeispiel auch an der Hochfrequenzantenneneinheit 20, angeordnet. Im vorliegenden Ausführungsbeispiel weist die Kommunikationseinheit 100 mehrere Mikrofoneinheiten 106 auf, die verteilt über dem Patientenaufnahmebereich 14 an der Gehäuseeinheit 28, im vorliegenden Ausführungsbeispiel auch an der Hochfrequenzantenneneinheit 20, angeordnet sind, so dass unabhängig von einer Patientenposition stets eine Kommunikation zwischen dem Patienten 15 und dem medizinischen Bedienpersonal möglich ist.

Die dargestellte Magnetresonanzvorrichtung 10 kann selbstverständlich weitere Komponenten umfassen, die Magnetresonanzvorrichtungen 10 gewöhnlich aufweisen. Eine allgemeine Funktionsweise einer Magnetresonanzvorrichtung 10 ist zudem dem Fachmann bekannt, so dass auf eine detaillierte Beschreibung der weiteren Komponenten verzichtet wird.

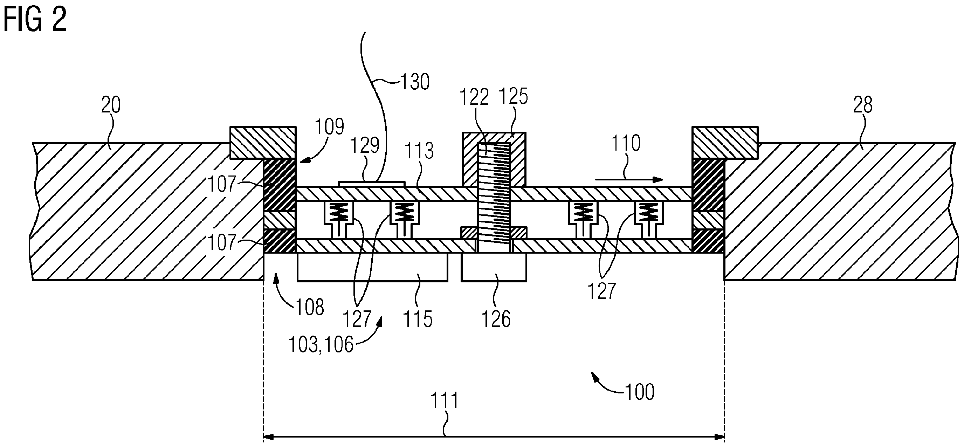

Ein Aufbau der Mikrofoneinheiten 106 wird im Folgenden an einer einzigen Mikrofoneinheit 106 näher erläutert, wobei die weiteren Mikrofoneinheiten 106 identisch zur der näher beschriebenen Mikrofoneinheit 106 ausgebildet sind. Der Aufbau der Mikrofoneinheit 106 ist in den Fig. 2 bis 6 näher beschrieben und dargestellt.

Die Mikrofoneinheit 106 weist zumindest ein Entkopplungselement 107 auf, wobei mittels des Entkopplungselements 107 eine schwingungsentkoppelte Anordnung und/oder Lagerung der Mikrofoneinheit 106 an der Gehäuseeinheit 28, im vorliegenden Ausführungsbeispiel auch an der Hochfrequenzantenneneinheit 20, erfolgt (Fig. 2). Im vorliegenden Ausführungsbeispiel umfasst die Mikrofoneinheit 106 zwei Entkopplungselemente 107, die jeweils einen Gummiring umfassen. In einer alternativen Ausgestaltung der Erfindung kann die Mikrofoneinheit 106 auch nur ein einziges Entkopplungselement 107 oder auch mehr als zwei Entkopplungselemente 107 aufweisen. Zudem können die einzelnen Entkopplungselemente 107 auch ein von einem Gummiring abweichendes Element aufweisen.

Für eine Anordnung der einzelnen Mikrofoneinheiten 106 an der Gehäuseeinheit 28, im vorliegenden Ausführungsbeispiel auch an der Hochfrequenzantenneneinheit 20, weist die Gehäuseeinheit 28, im vorliegenden Ausführungsbeispiel auch die Hochfrequenzantenneneinheit 20, für jede der Mikrofoneinheiten 106 jeweils eine Aussparung 108 auf (Fig. 1 und 2). Die einzelnen Aussparungen 108 sind jeweils zur Aufnahme einer der Mikrofoneinheiten 106 ausgelegt. Die einzelnen Aussparungen 106 weisen jeweils eine kreisförmige Aussparung 106 auf. Zudem weisen auch die einzelnen Mikrofoneinheiten 106 eine kreisförmige Ausbildung auf.

Die beiden Entkopplungselemente 107 der Mikrofoneinheit 106 sind an einem in radialer Richtung 110 äußeren Randbereich 109 der Mikrofoneinheit 106 angeordnet (Fig. 2). Mittels der Entkopplungselemente 107 kann derart ein Übergang zwischen der Mikrofoneinheit 106 und der Hochfrequenzantenneneinheit 20 schalldicht und/oder vibrationsdicht ausgebildet werden. Die Mikrofoneinheit 106 ist im vorliegenden Ausführungsbeispiel besonders bauraumsparend ausgebildet und weist einen maximalen Durchmesser 111 von 2 cm auf. In einer alternativen Ausgestaltung der Mikrofoneinheit 106 kann diese auch einen maximalen Durchmesser aufweisen, der größer als 2 cm ist.

Die Mikrofoneinheit 106 weist weiterhin ein Mikrofon-Board 112 und ein Anschluss-Board 113 auf (Fig. 2 bis 6). Das Mikrofon-Board 112 umfasst eine kreisförmig ausgebildete Platine. Zudem umfasst auch das Anschluss-Board 113 eine kreisförmig ausgebildet Platine, wobei das Mikrofon-Board 112 und das Anschluss-Board 112 einen im Wesentlichen gleichen Durchmesser 114 aufweisen (Fig. 2 bis 6). Aufgrund der bauraumsparenden Ausbildung der Mikrofoneinheit 106 im vorliegenden Ausführungsbeispiel sind auch da Mikrofon-Board 112 und das Anschluss-Board 113 im vorliegenden Ausführungsbeispiel besonders kompakt und klein ausgebildet. Bevorzugt weisen das Mikrofon-Board 112 und das Anschluss-Board 113 einen maximalen Durchmesser 114 von 1,5 cm auf. Bevorzugt weisen das Mikrofon-Board 112 und das Anschluss-Board 113 einen maximalen Durchmesser 114 von 1,0 cm auf.

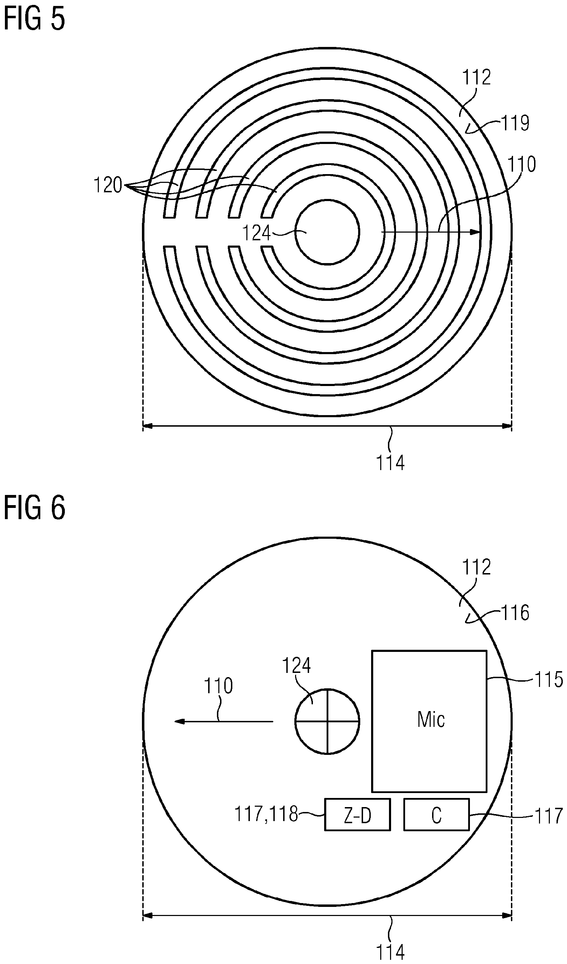

Das Mikrofon-Board 112 umfasst ein Mikrofon, das im vorliegenden Ausführungsbeispiel ein miniaturisiertes Mikrofon und/oder ein MEMS(Micro Electro Mechanical System)-Mikrofon 115 umfasst (Fig. 2 und 6). Das miniaturisierte Mikrofon und/oder das MEMS-Mikrofon 115 ist an einer Unterseite, insbesondere an einer dem Patientenaufnahmebereich 14 zugewandten Seite 116, der Mikrofoneinheit 106, insbesondere des Mikrofon-Boards 112, angeordnet. Das miniaturisierte Mikrofon und/oder das MEMS-Mikrofon 115 weist eine Länge und/oder Breite im mm-Bereich auf. Vorteilhafterweise umfasst das miniaturisierte Mikrofon und/oder das MEMS-Mikrofon 115 eine maximale Länge und/oder eine maximale Breite von 10 mm. Vorteilhafterweise umfasst das miniaturisierte Mikrofon und/oder das MEMS-Mikrofon 115 eine maximale Länge und/oder eine maximale Breite von 6 mm. In einer alternativen Ausgestaltung der Mikrofoneinheit 106, insbesondere in einer nicht miniaturisierten Ausbildung der Mikrofoneinheit 106, kann das Mikrofon auch eine größere Länge als 10 mm aufweisen.

Des Weiteren weist das Mikrofon-Board 112 zumindest ein weiteres elektronisches Bauteil 117 auf, das ebenfalls an der dem Patientenaufnahmebereich 14 zugewandten Seite 116 der Mikrofoneinheit 106, insbesondere des Mikrofon-Boards 112, angeordnet ist (Fig. 6). Im vorliegenden Ausführungsbeispiel weist das Mikrofon-Board 112 zwei weitere elektronische Bauelemente 117 auf, wobei die Erfindung nicht auf zwei weitere elektronische Bauelemente 117 beschränkt ist. Ein erstes elektronisches Bauelement 117 der zwei weiteren elektronischen Bauelemente 117 umfasst eine Diode 118, insbesondere eine Z-Diode und/oder eine Zener-Diode, das zu einem Schutz einer Spannungsversorgung des miniaturisierten Mikrofons und/oder das MEMS-Mikrofons 115 ausgelegt ist. Ein zweites elektronisches Bauelement 117 der zwei weiteren elektronischen Bauelemente 117 umfasst einen Kondensator, der zur Spannungsstabilisierung und/oder zur Ableitung von HF-Störsignalen ausgelegt ist. Sofern das Mikrofon ein größeres Mikrofon umfasst als ein miniaturisiertes Mikrofon und/oder ein MEMS-Mikrofon 115, kann zumindest ein weiteres Bauteil 117, wie beispielsweise die Diode 118, innerhalb des Mikrofons angeordnet und/oder integriert sein. Zudem kann das weitere Bauteil 117 auch an einer dem Patientenaufnahmebereich 14 abgewandten Seite des Mikrofon-Boards 112 angeordnet sein.

An einer Oberseite, insbesondere an einer dem Patientenaufnahmebereich 14 abgewandten Seite 119 und/oder einer dem Anschluss-Board 113 zugewandten Seite 119, des Mikrofon-Boards 112 weist das Mikrofon-Board 112 Leiterbahnen 120 auf (Fig. 5). Im vorliegenden Ausführungsbeispiel umfasst das Mikrofon-Board 112 vier Leiterbahnen 120. In einer alternativen Ausgestaltung des Mikrofon-Boards 112 kann dieses auch mehr als vier Leiterbahnen 120 oder auch weniger als vier Leiterbahnen 120 aufweisen. Die vier Leiterbahnen 120 sind als konzentrische Leiterbahnen 120 mit unterschiedlichen Durchmessern ausgebildet, wobei die einzelnen Leiterbahnen 120 an einer Stelle unterbrochen sind, um unerwünschte Wirbelströme zu vermeiden.

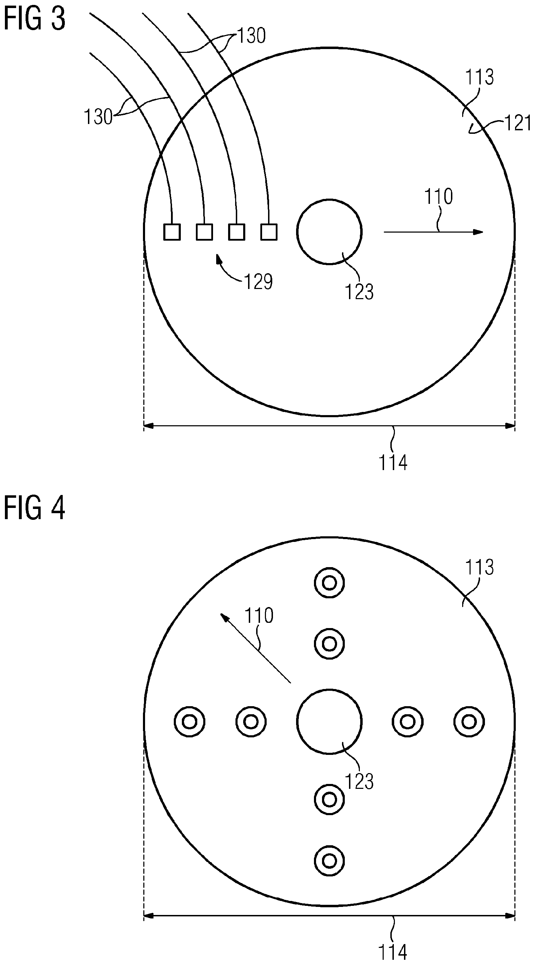

Das Anschluss-Board 113 umfasst eine Schnittstelle 129, die an einer Oberseite, insbesondere an einer dem Mikrofon-Board 112 abgewandten Seite 121, des Anschluss-Boards 113 angeordnet ist (Fig. 2 und 3). Im vorliegenden Ausführungsbeispiel umfasst die Schnittstelle 129 vier Anschlüsse, wobei mittels der vier Anschlüsse ein Signalaustausch innerhalb der Kommunikationseinheit 100 und/oder eine Spannungsversorgung der Mikrofoneinheit 106 erfolgt. Der Signalaustausch innerhalb der Kommunikationseinheit 100 bevorzugt mittels Signalkabel 130 (Fig. 2 und 3), beispielsweise elektrische und/oder optische Signalkabel. Zudem kann die Kommunikationseinheit 100 auch eine Auswerteeinheit 128 und/oder eine Steuereinheit aufweisen, die einen Signalaustausch von Kommunikationssignalen innerhalb der Kommunikationseinheit 100, insbesondere zwischen Benutzerseite und Patientenseite der Kommunikationseinheit 100, steuert und/oder regelt (Fig. 1).

Die Mikrofoneinheit 106 weist des Weiteren ein Verbindungselement 122 auf zur mechanischen Verbindung zwischen dem Anschluss-Board 113 und dem Mikrofon-Board 112 (Fig. 2). Im vorliegenden Ausführungsbeispiel umfasst das Verbindungselement 122 eine Schraube, insbesondere eine verliersicher ausgebildete Schraube. Grundsätzlich ist auch eine zu einer Schraube alternative Ausgestaltung des Verbindungselements 122 jederzeit möglich, wie beispielsweise ein Rastelement und/oder ein Klemmelement usw. Mittels des Verbindungselements 122, insbesondere der Schraube, ist das Mikrofon-Board 112 sicher an dem Anschluss-Board 113 angeordnet. Für die Anbringung des Verbindungselements 122, insbesondere der Schraube, weist das Anschluss-Board 113 in einer Mitte eine kreisförmige Aussparung 123 auf (Fig. 3 und 4). Zudem weist hierzu auch das Mikrofon-Board 112 in einer Mitte eine kreisförmige Aussparung 124 auf (Fig. 5 und 6). An der Oberseite, insbesondere der dem Mikrofon-Board 112 abgewandten Seite 121, des Anschluss-Boards 113 weist das Anschluss-Board 113 eine Gewindeaufnahme 125, insbesondere eine Schraubenmutter, auf. Ein Schraubenkopf 126 des Verbindungselements 122, insbesondere der Schraube, liegt dabei an der Unterseite, insbesondere an der dem Patientenaufnahmebereich 14 zugewandten Seite 116 des Mikrofon-Boards 112 und/oder an der dem Anschluss-Board 113 abgewandten Seite 16 des Mikrofon-Boards 112 an (Fig. 2).

Für einen Kontakt, insbesondere einen elektrischen Kontakt, zwischen dem Anschluss-Board 113 und dem Mikrofon-Board 112 weist die Mikrofoneinheit 106 zumindest ein in seiner Länge variables Kontaktelement 127 auf, die zwischen dem Anschluss-Board 113 und dem Mikrofon-Board 112 angeordnet ist. Im vorliegenden Ausführungsbeispiel weist die Mikrofoneinheit 106 acht in ihrer Länge variable Kontaktelemente 127 auf, die zwischen dem Anschluss-Board 113 und dem Mikrofon-Board 112 angeordnet sind. Die einzelnen in ihrer Länge variablen Kontaktelement 127 umfassen jeweils eine Kontaktfeder, wobei die Kontaktfedern im vorliegenden Ausführungsbeispiel als Miniatur-Kontaktfedern ausgebildet sind (Fig. 2).

Im vorliegenden Ausführungsbeispiel sind jeweils zwei Kontaktfedern, insbesondere zwei Miniatur-Kontaktfedern, in einer Gruppe angeordnet, wobei die einzelnen Gruppen in einer Umfangsrichtung um 90° versetzt zueinander auf dem Anschluss-Board 113 und/oder auf dem Mikrofon-Board 112 angeordnet sind. Zudem sind die beiden Kontaktfedern, insbesondere die Miniatur-Kontaktfedern, innerhalb einer Gruppe in radialer Richtung 110 des Anschluss-Boards 113 und/oder des Mikrofon-Boards 112 von der mittigen Aussparung 123, 124 nach außen nacheinander angeordnet (Fig. 4). Die einzelnen Kontaktfedern, insbesondere die Miniatur-Kontaktfedern, sind zudem derart angeordnet, das die einzelnen Kontaktfedern, insbesondere die Miniatur-Kontaktfedern, mit dem Mikrofon-Board 112 zugwandte Ende der Kontaktfedern, insbesondere die Miniatur-Kontaktfedern, jeweils mit einer der Leiterbahnen 120 des Mikrofon-Boards 112 kontaktieren.

Bevorzugt ist ein Abstand zwischen dem Anschluss-Board 113 und dem Mikrofon-Board 112 auf einen Arbeitsbereich und/oder einer Arbeitslänge der Kontaktfedern, insbesondere der Miniatur-Kontaktfedern, abgestimmt. Im vorliegenden Ausführungsbeispiel ist der Arbeitsbereich und/oder die Arbeitslänge der Kontaktfedern, insbesondere der Miniatur-Kontaktfedern, beispielhaft zwischen 2,2 mm und 2,4 mm. Somit beträgt auch der Abstand zwischen dem Anschluss-Board 113 und dem Mikrofon-Board 112 beispielhaft zwischen 2,2 mm und 2,4 mm.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, vorausgesetzt, der resultierende Gegenstand fällt in den Schutzbereich der Erfindung, wie er in den Ansprüchen definiert ist.

## Patentansprüche

1. Magnetresonanzvorrichtung mit einer Scannereinheit (11), einem von der Scannereinheit (11) zumindest teilweise umgebenen Patientenaufnahmebereich (14), wobei die Scannereinheit(11) eine Gehäuseeinheit (28) umfasst, die den Patientenaufnahmebereich (14) zumindest teilweise umgibt, und einer Kommunikationseinheit (100) mit zumindest einer Mikrofoneinheit (106), wobei die zumindest eine Mikrofoneinheit (106) zumindest ein Entkopplungselement (107) aufweist mittels des zumindest einen Entkopplungselements (107) schwingungsentkoppelt an der Gehäuseeinheit (28) angeordnet ist, **dadurch gekennzeichnet, dass** die zumindest eine Mikrofoneinheit (106) ein Anschluss-Board (113) und ein Mikrofon-Board (112) mit einem Mikrofon (115) aufweist und die zumindest eine Mikrofoneinheit (106) zwei oder mehr in ihrer Länge variable Kontaktelemente (127) aufweist, die jeweils eine Kontaktfeder umfassen und die zwischen dem Anschluss-Board (113) und dem Mikrofon-Board (112) auf der dem Anschluss-Board zugewandten Seite angeordnet sind, wobei das Mikrofon-Board (112) konzentrische Leiterbahnen (120) aufweist, die an zumindest einer Stelle unterbrochen sind, wobei die zwei oder mehr Kontaktfedern derart auf der dem Mikrophon-Board zugewandten Seite des Anschluss-Boards angeordnet sind, dass die einzelnen Kontaktfedern mit dem dem Mikrofon-Board (112) zugewandten Ende der Kontaktfedern jeweils mit einer der Leiterbahnen (120) des Mikrofon-Boards (112) kontaktieren.

2. Magnetresonanzvorrichtung nach Anspruch 1,
**dadurch gekennzeichnet, dass** die Gehäuseeinheit (28) zumindest eine Aussparung (108) zu einer Aufnahme der zumindest einen Mikrofoneinheit (106) aufweist.

3. Magnetresonanzvorrichtung nach Anspruch 2,
**dadurch gekennzeichnet, dass** das zumindest eine Entkopplungselement (107) an einem Randbereich (109) der Aussparung (108) angeordnet ist.

4. Magnetresonanzvorrichtung nach einem der vorhergehenden Ansprüche,
**dadurch gekennzeichnet, dass** das Mikrofon an einer dem Patientenaufnahmebereich (14) zugewandten Seite des Mikrofon-Boards (112) angeordnet ist.

5. Magnetresonanzvorrichtung nach einem der vorhergehenden Ansprüche,
**dadurch gekennzeichnet, dass** das Anschluss-Board (113) eine Schnittstelle (129) aufweist.

6. Magnetresonanzvorrichtung nach einem der vorhergehenden Ansprüche,
**dadurch gekennzeichnet, dass** die zumindest eine Mikrofoneinheit (106) ein Verbindungselement (122) zur mechanischen Verbindung des Anschluss-Boards (113) mit dem Mikrofon-Board (112) aufweist.

7. Magnetresonanzvorrichtung nach einem der vorhergehenden Ansprüche,
**dadurch gekennzeichnet, dass** das Anschluss-Board (113) konzentrische Leiterbahnen (120) aufweist, die an zumindest einer Stelle unterbrochen sind.

8. Magnetresonanzvorrichtung nach einem der vorhergehenden Ansprüche,
**dadurch gekennzeichnet, dass** die zumindest eine Mikrofoneinheit (106) zumindest ein weiteres elektronisches Bauelement (117) aufweist.

9. Magnetresonanzvorrichtung nach Anspruch 8,
**dadurch gekennzeichnet, dass** das zumindest eine elektronische Bauelement (117) zumindest eine Diode (118) aufweist.

10. Magnetresonanzvorrichtung nach einem der vorhergehenden Ansprüche,
**dadurch gekennzeichnet, dass** die zumindest eine Mikrofoneinheit (106) einen Durchmesser (111) von maximal 2 cm aufweist.

11. Magnetresonanzvorrichtung nach einem der vorhergehenden Ansprüche,
**dadurch gekennzeichnet, dass** die Scannereinheit (11) eine fest in der Scannereinheit (11) angeordnete Hochfrequenzantenneneinheit (20) aufweist, wobei die Hochfrequenzantenneneinheit (20) einstückig mit der Gehäuseeinheit (28) ausgebildet ist.

## Claims

1. Magnetic resonance apparatus with a scanner unit (11), a patient receiving region (14) surrounded at least partially by the scanner unit (11), wherein the scanner unit (11) comprises a housing unit (28), which at least partially surrounds the patient receiving region (14), and a communication unit (100) with at least one microphone unit (106), wherein the at least one microphone unit (106) has at least one decoupling element (107) is arranged on the housing unit (28) in a vibrationdecoupled manner by means of the at least one decoupling element (107),
**characterised in that** the at least one microphone unit (106) has a terminal board (113) and a microphone board (112) with a microphone (115) and the at least one microphone unit (106) has two or more contact elements (127) which can vary in terms of their length and which each comprise a contact spring and which are arranged between the terminal board (113) and the microphone board (112) on the side facing the terminal board, wherein the microphone board (112) has concentric conductor paths (120), which are interrupted at at least one point, wherein the two or more contact springs are arranged on the side of the terminal board facing the microphone board such that the individual contact springs with the end of the contact springs facing the microphone board (112) each make contact with one of the conductor paths (120) of the microphone board (112).

2. Magnetic resonance apparatus according to claim 1, **characterised in that** the housing unit (28) has at least one cut-out (108) for receiving the at least one microphone unit (106) .

3. Magnetic resonance apparatus according to claim 2, **characterised in that** the at least one decoupling element (107) is arranged on an edge region (109) of the cut-out (108) .

4. Magnetic resonance apparatus according to one of the preceding claims,
**characterised in that** the microphone is arranged on a side of the microphone board (112) facing the patient receiving region (14) .

5. Magnetic resonance apparatus according to one of the preceding claims,
**characterised in that** the terminal board (113) has an interface (129).

6. Magnetic resonance apparatus according to one of the preceding claims, **characterised in that** the at least one microphone unit (106) has a connection element (122) for mechanically connecting the terminal board (113) with the microphone board (112).

7. Magnetic resonance apparatus according to one of the preceding claims,
**characterised in that** the terminal board (113) has concentric conductor paths (120) which are interrupted at at least one point.

8. Magnetic resonance apparatus according to one of the preceding claims,
**characterised in that** the at least one microphone unit (106) has at least one further electronic component (117).

9. Magnetic resonance apparatus according to claim 8, **characterised in that** the at least one electronic component (117) has at least one diode (118).

10. Magnetic resonance apparatus according to one of the preceding claims,
**characterised in that** the at least one microphone unit (106) has a diameter (111) of at most 2 cm.

11. Magnetic resonance apparatus according to one of the preceding claims,
**characterised in that** the scanner unit (11) has a high-frequency antenna unit (20) arranged in the scanner unit (11), wherein the high-frequency antenna unit (20) is embodied integrally with the housing unit (28).

## Revendications

1. Installation de résonance magnétique comprenant une unité (11) de scanner, une partie (14) de réception d'un patient entourée au moins en partie de l'unité (11) de scanner, dans laquelle l'unité (11) de scanner comprend une unité (28) d'enveloppe, qui entoure au moins en partie la partie (14) de réception d'un patient, et une unité (100) de communication ayant au moins une unité (106) de microphone, dans laquelle la au moins une unité (106) de microphone a au moins un élément (107) de découplage, au moyen duquel au moins un élément (107) de découplage elle est montée découplée en vibrations de l'unité (28) d'enveloppe,
**caractérisée en ce que** la au moins une unité (106) de microphone a un board (113) de connexion et un board (112) de microphone ayant un microphone (115) et la au moins une unité (106) de microphone a deux ou plusieurs éléments (127) de contact de longueur variable, qui comprennent chacun un ressort de contact et qui sont disposés entre le board (113) de connexion et le board (112) de microphone du côté tourné vers le board de connexion, dans laquelle le board (112) de microphone a des pistes (120) conductrices concentriques, qui sont interrompues en au moins un endroit, dans laquelle les deux ou plusieurs ressorts de contact sont disposés sur la face, tournée vers le board de microphone, du board de connexion, de manière à ce que les ressorts de contact individuels contactent par l'extrémité tournée vers le board (112) de microphone respectivement l'une des pistes (120) conductrices du board (112) de microphone.

2. Installation de résonance magnétique suivant la revendication 1,
**caractérisée en ce que** l'unité (28) d'enveloppe a au moins un évidement (108) de réception de la au moins une unité (106) de microphone.

3. Installation de résonance magnétique suivant la revendication 2,
**caractérisée en ce que** le au moins un élément (107) de découplage est monté sur une partie (109) de bord de l'évidement (108) .

4. Installation de résonance magnétique suivant l'une des revendications précédentes,
**caractérisée en ce que** le microphone est disposé sur une face du board (112) de microphone tournée vers la partie (14) de réception d'un patient.

5. Installation de résonance magnétique suivant l'une des revendications précédentes,
**caractérisée en ce que** le board (113) de connexion a une interface (129).

6. Installation de résonance magnétique suivant l'une des revendications précédentes,
**caractérisée en ce que** la au moins une unité (106) de microphone a un élément (122) d'assemblage pour l'assemblage mécanique du board (113) de connexion au board (112) de microphone.

7. Installation de résonance magnétique suivant l'une des revendications précédentes,
**caractérisée en ce que** le board (113) de connexion a des pistes (120) conductrices concentriques, qui sont interrompues en au moins un endroit.

8. Installation de résonance magnétique suivant l'une des revendications précédentes,
**caractérisée en ce que** la au moins une unité (106) de microphone a au moins un autre composant (117) électronique.

9. Installation de résonance magnétique suivant la revendication 8,
**caractérisée en ce que** le au moins un élément (117) électronique comporte au moins une diode (118).

10. Installation de résonance magnétique suivant l'une des revendications précédentes,
**caractérisée en ce que** la au moins une unité (106) de microphone a un diamètre (111) de 2 cm au maximum.

11. Installation de résonance magnétique suivant l'une des revendications précédentes,
**caractérisée en ce que** l'unité (11) de scanner a une unité (20) d'antenne en haute fréquence montée fixe dans l'unité (11) de scanner, dans laquelle l'unité (20) d'antenne de haute fréquence est constituée d'une seule pièce avec l'unité (28) d'enveloppe.
